# EUROPÄISCHE PATENTSCHRIFT

(11) **EP 1 738 392 B1**
(45) Veröffentlichungstag und Bekanntmachung des Hinweises auf die Patenterteilung: **09.05.2012**
(21) Anmeldenummer: 05716895.7
(22) Anmeldetag: 03.03.2005
(51) Int. Cl.: H01J 37/317, H01J 37/141, H01J 37/30, H01J 37/153

(54) **BELEUCHTUNGSKONDENSOR FÜR EIN PARTIKELOPTIK - PROJEKTIONSSYSTEM**
ILLUMINATION CONDENSER FOR A PARTICLE OPTICAL PROJECTION SYSTEM
CONDENSATEUR D'ECLAIRAGE DESTINE A UN SYSTEME PROJECTEUR A PARTICULES

(30) Priorität: 23.04.2004 DE 102004019835
(43) Veröffentlichungstag der Anmeldung: 03.01.2007
(73) Patentinhaber: Vistec Electron Beam GmbH, 07745 Jena (DE)
(72) Erfinder: DOERING, Hans-Joachim, 07749 Jena (DE); ELSTER, Thomas, 07745 Jena (DE)
(74) Vertreter: Freitag, Joachim
(86) Internationale Anmeldenummer: PCT/EP2005/050941
(87) Internationale Veröffentlichungsnummer: WO 2005/104170

(56) Entgegenhaltungen:
- DE-A1- 1 564 761
- US-A- 4 468 563

## Beschreibung

Die Erfindung betrifft einen Beleuchtungskondensor für ein Partikeloptik - Projektionssystem.

In der Halblefterfertigung ist es oft erforderlich, dass ein Objekt (Maske bzw. Vielstrahlmodulator) mit Hilfe eine Kondensors telezentrisch beleuchtet wird, dabei wird üblicherweise aufgrund der sphärischen Aberration des Kondensors der partielle Crossover eines achsfernen Punktes auf der Maske von der Achse weggelenkt, was zu zusätzlichen Fehlern (schräger Strahleinfall im Target, Astigmatismus und/oder Verzeichnung) führt. Die Außeraxialität des Crossovers führt zu zusätzlichen Aberrationen im Partikularoptik-Projektionsgerät, da die Strahlen die Linsenfelder in größerer Entfernung von der Achse passieren. Die Außeraxialität des partiellen Crossovers wird wesentlich verursacht durch die sphärische Aberration des Beleuchtungs-Kondensors. Die Wirkung der sphärischen Aberration des Beleuchtungs-Kondensors ist proportional zur dritten Potenz der im Crossover wirksamen Apertur. Diese Apertur ist bei Großfeld-Partikeloptik-Projektionssystemen sehr groß, typisch 100 mrad. Sie kann bei vorhandenem Beleuchtungskondensor nur durch einen sehr großen Abstand zwischen der Partikel-Quelle und der Maske / des Multiapertur-Vielstrahlmodulators reduziert werden. Dies führt jedoch zu extremer Bauhöhe des Partikularstrahl-Projektionsgerätes.

Im US-Patent 4,468,563 und in der DE 15 64 761 A1 werden jeweils Zweispaltlinsen für Elektronenmikroskope beschrieben, bei denen eine Umschaltung von geringer zu starker Fokussierung durch einen ferromagnetischen Shunt (magnetischen Bypass) in einem der Polspalte möglich ist. Dabei wird die Spaltlinse, die aus nur einem Eisenkreis mit einer Wicklung besteht, über eine mehr oder minder starke Anregung zwischen Ein- oder Zweispaltlinse umgeschaltet

Im U.S. Patent 5,742,062 ist eine elektrostatische Linse beschrieben, die aus einer Vielzahl ringförmiger Elektroden besteht, an die verschiedene Potentiale angelegt sind. Diese Linse ist geeignet, eine großflächige, parallele Beleuchtung eines Objektes (Maske) mit geladenen Teilchen zu ermöglichen. Durch geeignete Wahl der Elektrodenpotentiale ist es möglich, die Linsenaberrationen zu minimieren. Nachteilig ist der große technische Aufwand zur Bereitstellung einer Vielzahl unterschiedlicher Potentiale mit hoher zeitlicher Konstanz. Für den Fall hoher Strahlenergie (50...200keV) sind die notwendigen Isolationsstrecken lang, die Vakuumdurchführungen entsprechend groß und damit auch das benötigte Vakuumvolumen für diese Anordnung- Daraus folgt der Nachteil, dass die Abschirmung des Partikelstrahls gegen magnetische Störfelder sehr aufwendig ist, da geeignete Abschimizylinder z.B. aus Mu-Metall einen großen Radius und dicke Wandstärke benötigen. Weiterhin ist die Gasabgabe der großen Oberfläche der Elektroden und Isolatoren nachteilig für den angestrebten niedrigen Enddruck im Rezipienten und eine entsprechend geringe Kontaminationsrate.

Das Paper von Rose zur magnetisch-elektrostatischen Multielektroden-Linse; D. Preikszas, H. Rose, Optik 100 (1995), 179; offenbart eine kombinierte magnetisch-elektrostatische Linse, die aus einer Anzahl identischer Elemente (Aperturen, Ringströme) besteht, die so angesteuert werden, dass Aberrationen weitgehend unterdrückt werden.

Der Stand der Technik ist dadurch gekennzeichnet, dass die sphärische Aberration des Beleuchtungs-Kondensors in Partikutarstrahi-Projektionsgeräten nicht bzw. nur über die große radiale Ausdehnung des Kondensors reduziert wird. Das beschränkt wesentlich die mögliche Größe der Maske und/oder des Muttiapertur-Strahimodulators. Es gibt lediglich Versuche, mit elektrostatischen Kondensorlinsen, die sehr viele Elektroden besitzen (Muttiapertur-Kondensor), eine solche Form des elektrostatischen Feldes des Kondensors zu erzielen, dass die sphärische Aberration weitgehend unterdrückt wird. Ein solcher elektrostatischer Multiapertur-Kondensor erfordert jedoch eine Vielzahl von Hochspannungs-Versorgungen für die einzelnen Elektroden und ist deshalb nur beschränkt verwendbar.

Der Erfindung liegt die Aufgabe zugrunde, ein Projektionsgerät zur Belichtung von Substraten derart auszugestalten, dass eine Maske oder ein Multiapertur-Strahlmodulator vorzugsweise telezentrisch beleuchtet werden. Dabei soll die Bauhöhe des Projektionsgeräts in vernünftigen Grenzen gehalten werden.

Diese Aufgabe wird durch ein System mit den Merkmalen des Anspruchs 1 gelöst.

Es ist von Vorteil, wenn der Beleuchtungskondensor für ein Partikeloptik - Projektionssystem aus einer magnetischen Linse aufgebaut ist, und dass die magnetische Linse mehrere Spalte umfasst. Dabei ist die Anzahl der Spalte zweckmäßig größer oder gleich fünf.

Vorteilhaft ist in der aus einer Sequenz von mehreren partiellen Linsen zusammengesetzten magnetischen Linse mit jeweils separaten Wicklungen jede Wicklung einzeln ansteuerbar. Mindestens zwei benachbarte partielle Linsen besitzen vorzugsweise einen gemeinsamen Polschuh.

Ferner ist von Vorteil, wenn der Beleuchtungskondensor derart ausgestaltet ist, dass die Aberration des Quell-Crossover minimiert ist, wobei die radiale Ausdehnung, der maximale Bohrungsradius Rₖ des Beleuchtungskondensors einen Wert aufweist, der kleiner als 150 mm ist.

Weiterhin kann es von Vorteil sein, dass ein derartiger Beleuchtungskondensor mit einer elektrostatischen Zerstreuungslinse kombiniert wird, was die Aberrationen weiter minimiert.

Des Weiteren kann es von Vorteil sein, dass ein derartiger Beleuchtungskondensor als Mehrspalt-Dublette (Zwei Mehrspalt-Linsen hintereinander mit entgegengesetzter Bilddrehung) ausgeführt wird. In diesem Fall würden sich anisotrope Restfehler kompensieren.

Es ist von besonderem Vorteil, wenn die Beleuchtung der Maske derart erfolge, dass der partielle Crossover eines Punktes auf der Maske oder des Multiapertur-Strahlmodulators so weit wie möglich auf der optischen Achse des Partikelstrahl-Projektionsgerätes verbleibt.

In der Zeichnung ist der Erfindungsgegenstand schematisch dargestellt und wird anhand der Figuren nachfolgend beschrieben. Dabei zeigen:
Fig. 1 eine schematische Darstellung des Strahlengangs in einem Partikeloptik - Projektionssystem;
Fig. 2 ein Ausführungsbeispiel eines erfindungsgemäßen magnetischen Beleuchtungskondensors; und
Fig. 3 eine Ansicht der axialen Feldverteilung des magnetischen Beleuchtungskondensors;

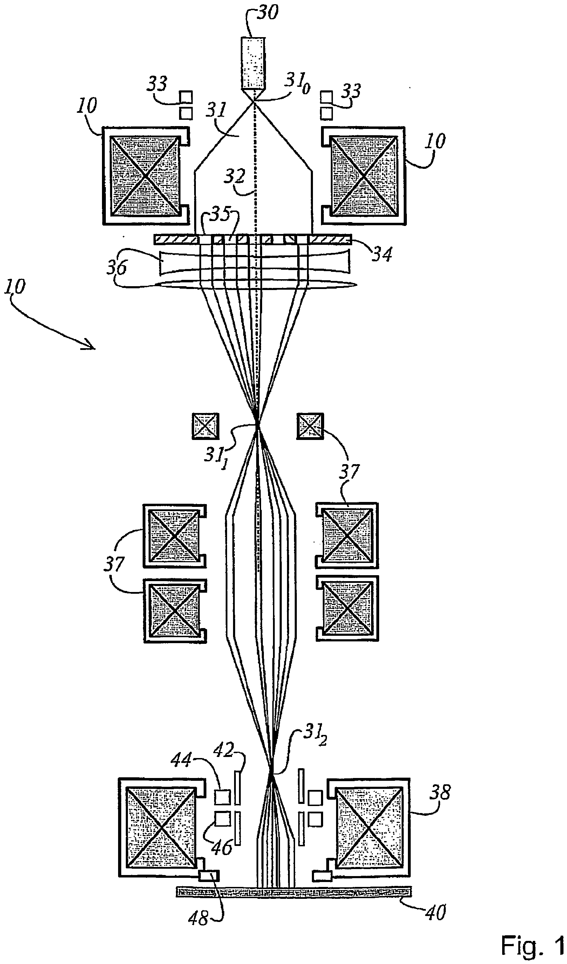

Fig. 1 zeigt den prinzipiellen Strahlengang in einem Partikeloptik - Projektionssystem 2. In der nachstehenden Beschreibung wird das Partikeloptik - Projektionssystem 2 beschrieben, dabei sind die Partikel Elektronen. Von einer Elektronenkanone (Partikelkanone) 30 wird ein Elektronenstrahl 31 erzeugt, der sich in Richtung einer elektronenoptischen Achse 32 ausbreitet. Die aus der Elektronenkanone 30 austretenden Elektronen weisen einen Quell-Crossover 31ₒ auf. Der Elektronenkanone 30 ist eine Strahlzentriereinrichtung 33 nachgeschaltet, die den Elektronenstrahl 31 symmetrisch um die optische Achse 32 ausrichtet. Nach der Strahlzentriereinrichtung durchläuft der Elektronenstrahl 31 einen Beleuchtungskondensor 10, der aus dem anfänglich divergenten Elektronenstrahl 31 einen parallelen Strahl formt. Der durch den Beleuchtungskondensor 10 geformte Strahl besitzt einen Durchmesser, über den die Intensität homogen verteilt ist. Nach dem Beleuchtungskondensor 10 ist eine Aperturplatte 34, mit einer Vielzahl von Öffnungen 35 für den Elektronenstrahl vorgesehen. Nach der Aperturplatte 34 folgt eine Beschleunigungslinse 36, an die sich mindestens eine magnetische Linse 50 zur Strahldrehung anschließt. In dem hier dargestellten Ausführungsbeispiel sind zwei weitere magnetische Linsen 37 gezeigt, die der verkleinernden Abbildung der Aperturplatte 34 dienen. Bevor der Elektronenstrahl 31 auf ein Target 40 trifft, das z.B. ein Wafer ist, durchläuft der Elektronenstrahl 31 eine Objektivlinse 38. Die Objektivlinse 38 ist mit einer Vielzahl von Elementen ausgestattet. Vor und nach einem zweiten Crossover 31₂ des Elektronenstrahls 31 ist eine Ablenkeinrichtung 42 vorgesehen. Die Ablenkeinrichtung 42 dient zum Auslenken und zur Lagebestimmung des Elektronenstrahls 31 bzw. der Vielzahl der Einzelstrahlen, die durch die Aperturplatte 34 erzeugt werden. Ferner ist eine Fokussierlinse 44 für die dynamische Fokussierung und eine Spulenanordnung 46, die als Stigmator wirkt, vorgesehen. Die Objektivlinse 38 besitzt an der dem Target 40 gegenüberliegenden Stelle einen Höhensensor 48 und einen Detektor für die vom Target 40 rückgestreuten Elektronen.

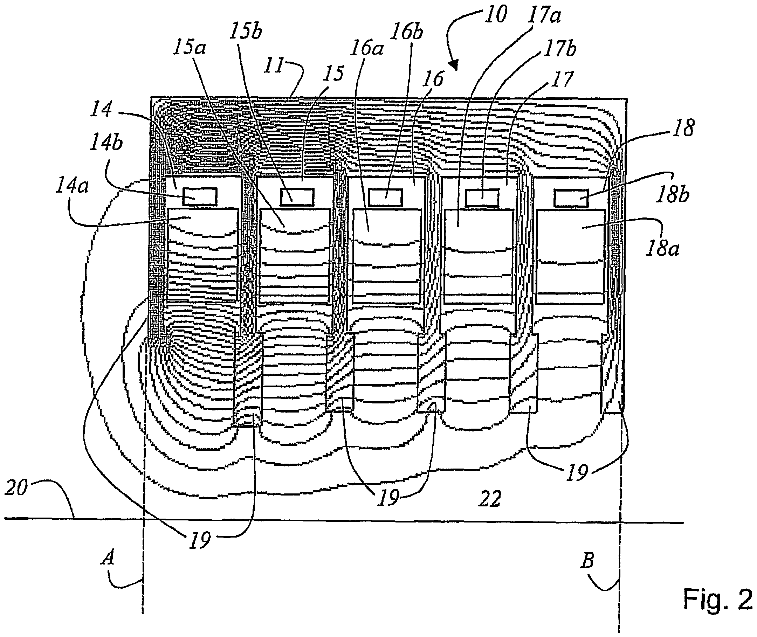

Fig. 2 zeigt eine Ausführungsform eines erfindungsgemäßen Beleuchtungskondensors 10. Der Beleuchtungskondensor 10 besteht aus einer magnetischen Linse 11, die aus einer Vielzahl von Spalten 12 aufgebaut ist. Bevorzugt ist eine Spaltenzahl ny >= 5. Der Beleuchtungskondensor 10 stellt eine magnetische Linse mit einer langen Brennweite dar. Die Brennweite beträgt typisch um die 500mm. Der aus dem Beleuchtungskondensor 10 austretende Partikelstrahl beleuchtet, vorzugsweise telezentrisch, eine Maske oder einen Multiapertur-Strahlmodulator oder eine Aperturplatte 40. Dazu ist es erforderlich, dass der Quell-Crossover 31ₒ im objektseitigen Brennpunkt des Beleuchtungskondensors 10 steht, d.h., der Quell-Crossover 31ₒ wird ins Unendliche abgebildet. Bei dem in Fig. 2 dargestellten Ausführungsbeispiel eines erfindungsgemäßen magnetischen Beleuchtungskondensors 10 umfasst die magnetische Linse 11 fünf Spalte. Der Beleuchtungskondensor 10 besteht demzufolge aus einer Sequenz von mehreren partiellen Linsen 14, 15, 16, 17 und 18, die im Strahlengang 20 des Partikularoptik-Projektionsgerätes 2 vor der Maske oder einer Aperturplatte 40 angeordnet sind und diese vorzugsweise telezentrisch beleuchten. Jede partielle Linse 14, 15, 16, 17, 18 hat dabei eine erste Wicklung 14a, 15a, 16a, 17a, 18a mit separat einstellbarer Erregung. Vorteilhaft kann die Einstellung der separaten Erregungen der partiellen Linsen auch über eine individuelle Windungszahl für die ersten Wicklungen 14a, 15a, 16a, 17a, 18a erfolgen, wobei die Stromversorgung der in Reihenschaltung betriebenen Wicklungen dann aus einer gemeinsamen Stromquelle erfolgt. Weiterhin kann es von Vorteil sein, zusätzlich zu den ersten Wicklungen (Grobwicklungen) 14a, 15a, 16a, 17a, 18a,, zweite Wicklungen (Feinwicklungen) 14b, 15b, 16b, 17b, 18b vorzusehen. Die zweiten Wicklungen (Feinwicklungen) 14b, 15b, 16b, 17b, 18b besitzen vorzugsweise individuelle Windungszahlen für jede partielle Linse 14, 15, 16, 17, 18. Mittels Erregungsvariation der in Reihenschaltung betriebenen Feinwicklungen kann auf einfache Weise eine feinfühlige Brennweittenvariation erfolgen, wenn gleichzeitig die Reihenschaltung der Grobwicklungen aus einer gemeinsamen Konstantstromquelle erfolgt. Zwei benachbarte partielle Linsen besitzen einen gemeinsamen Polschuh 19. Die Erregungen und Spalte der partiellen Linsen 14, 15, 16, 17, 18 sowie die Durchmesser der Polschuhe 19 sind voneinander verschieden. Bei dem in Fig. 2 dargestellten Ausführungsbeispiel mit fünf Spalten können insgesamt sechzehn Parameter individuell dabei so gewählt werden, dass die sphärische Aberration des Beleuchtungskondensors 10 bei der Abbildung des Quell-Crossover 31ₒ minimiert ist. Dies geschieht unter der Nebenbedingung, dass die radiale Ausdehnung, der maximale Bohrungsradius Rₖ des Beleuchtungskondensors 10 eine gewisse Größe nicht übersteigt. Eine typische Größe für den Bohrungsradius Rₖ des Beleuchtungskondensors 10 ist dabei kleiner als 150 mm. Der Beleuchtungskondensor 10 ist in der Darstellung der Fig. 2 lediglich zur Hälfte dargestellt. Der Beleuchtungskondensor ist um eine Achse 21 des Strahlengangs 20 rotationssymmetrisch. Der Strahlengang 20 durchläuft den Beleuchtungskondensor 10 von einem Strahleintritt A zu einem Strahlaustritt B. Die magnetischen Feldlinien 22 bilden sich bei dem Beleuchtungskondensor 10 der gegenwärtigen Erfindung derart aus, dass sie weiter von der Achse 21 des Strahlengangs 20 zurücktreten je mehr man sich dem Punkt B des Beleuchtungskondensors 10 nähert. Mit anderen Worten, ist die durch die magnetischen Feldlinien 22 dargestellte magnetische Feldstärke 24 am Strahlaustritt A des Beleuchtungskondensors 10 geringer als am Strahleintritt B.

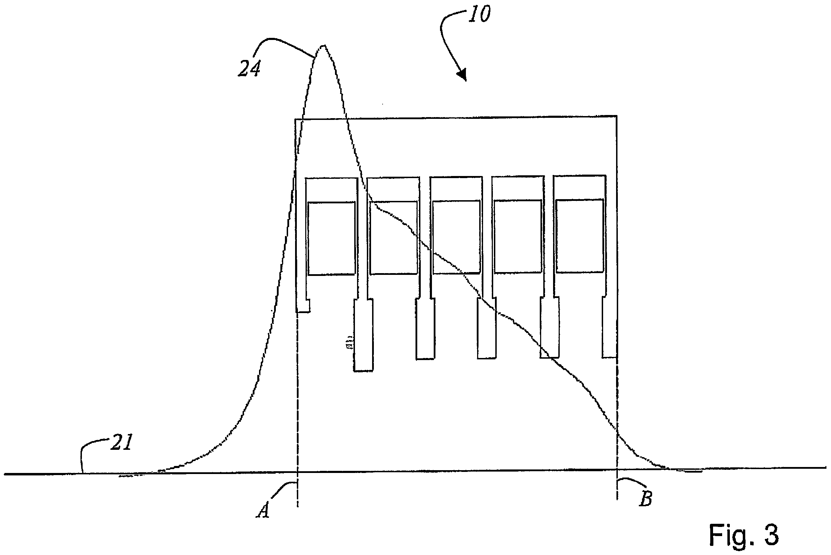

Figur 3 zeigt den Verlauf der axialen Feldverteilung eines optimierten Beleuchtungskondensors 10. Da der Quell-Crossover 31ₒ vorzugsweise ins Unendliche abgebildet wird, erfolgt die Optimierung des Beleuchtungskondensors 10 derart, dass der Quotient aus Crossover-Fehlerscheibchen und Crossover-Durchmesser minimal wird, wenn der Crossover im Grenzfall gegen Unendlich geht. Die magnetische Feldstärke 24 des erfindungsgemäßen Beleuchtungskondensors 10 ist in Abhängigkeit von der Lage bezüglich der Achse 21 des Strahlenganges dargestellt. Dabei ist zu erkennen, dass die magnetische Feldstärke 24 im Bereich von Punkt A stark zunimmt und auf kurzer Distanz ein Maximum erreicht. Vom Maximum ausgehend fällt die magnetische Feldstärke 24 dann kontinuierlich ab und erreicht in etwa beim Punkt B den Wert Null.

Die Erfindung wurde bezüglich eines besonderen Ausführungsbeispiels beschrieben, es ist jedoch für jeden Fachmann selbstverständlich, dass im Rahmen des handwerklichen Könnens eines Fachmanns Änderungen und Abwandlungen durchgeführt werden können ohne dabei den Schutzbereich der nachstehenden Patentansprüche zu verlassen.

## Patentansprüche

1. Beleuchtungskondensor (10) für ein Partikeloptik-Projektionssystem mit einem Beleuchtungskondensor (10) aus einer magnetischen Linse (11), die mehrere Spalte aufweist, **dadurch gekennzeichnet, dass** die magnetische Linse aus einer Sequenz von mehreren partiellen Linsen (14, 15, 16, 17, 18) aufgebaut ist, wobei
die partiellen Linsen (14, 15, 16, 17, 18) jeweils eine separate Wicklung (14a, 15a, 16a, 17a, 18a) aufweisen.

2. Beleuchtungskondensor nach Anspruch 1, **dadurch gekennzeichnet, dass** die Anzahl der Spalte größer als fünf ist.

3. Beleuchtungskondensor nach Anspruch 1, **dadurch gekennzeichnet, dass** die Anzahl der Spalte gleich fünf ist.

4. Beleuchtungskondensor nach Anspruch 1, **dadurch gekennzeichnet, dass** jede der separaten Wicklungen (14a, 15a, 16a, 17a, 18a) der mehreren partiellen Linsen (14, 15, 16, 17, 18) einzeln ansteuerbar ist.

5. Beleuchtungskondensor nach Anspruch 1, **dadurch gekennzeichnet, dass** jede der mehreren partiellen Linsen (14, 15, 16, 17, 18) erste separate Wicklungen (14a, 15a, 16a, 17a, 18a) und zweite separate Wicklungen (14b, 15b, 16b, 17b, 18b) enthält, wobei das Verhältnis der Windungszahlen der ersten (14a,15a,16a,17a,18a) bzw. der zweiten Wicklungen (14b,15b,16b,17b,18b) so gewählt ist, dass die partiellen Linsen (14, 15, 16, 17, 18) die gewünschte Erregung erhalten, wenn die ersten Wicklungen (14a, 15a, 16a, 17a, 18a) in Reihenschaltung und die zweiten Wicklungen (14b, 15b, 16b, 17b, 18b) in Reihenschaltung betrieben werden.

6. Beleuchtungskondensor nach Anspruch 5, **dadurch gekennzeichnet, dass** die ersten Wicklungen (Grobwicklungen) (14a, 15a, 16a, 17a, 18a) der partiellen Linsen (14, 15, 16, 17, 18) von demselben konstanten Strom durchflutet sind und die zweiten Wicklungen (Feinwicklungen) (14b, 15b, 16b, 17b, 18b) der partiellen Linsen (14, 15, 16,17,18) infolge individueller Windungszahlen in einer Reihenschaltung unterschiedliche Erregung aufweisen, wenn sie vom selben Strom durchflutet sind, wobei mittels Stromvariation der in Reihenschaltung betriebenen Feinwicklungen (14b, 15b, 16b, 17b, 18b) eine feinfühlige Brennweitenvariation einstellbar ist**.**

7. Beleuchtungskondensor nach Anspruch 1, **dadurch gekennzeichnet, dass** mindestens zwei benachbarte, partielle Linsen (14, 15. 16, 17, 18) einen gemeinsamen Polschuh (19) besitzen, wobei die zwischen den Polschuhen (19) befindlichen Spalte der partiellen Linsen (14, 15, 16, 17, 18) und/oder die Durchmesser der Polschuhe (19) voneinander verschieden sind.

8. Beleuchtungskondensor nach einem der Ansprüche 1 bis 7, **dadurch gekennzeichnet, dass** das Partikeloptik-Projektionssystem (2) eine optische Achse (32) definiert, um die der Beleuchtungskondensor (10) rotationssymmetrisch aufgebaut ist.

9. Beleuchtungskondensor nach Anspruch 8, **dadurch gekennzeichnet, dass** die Aberration eines Quell-Crossover (310) minimiert ist, wobei ein maximaler Bohrungsradius Rk des Beleuchtungskondensors (10) einen Wert aufweist, der kleiner als 150 mm ist.

10. Beleuchtungskondensor nach Anspruch 9, **dadurch gekennzeichnet, dass** die magnetische Feldstärke (24) Ober Jede der partiellen Linsen (14, 15, 16, 17, 18) geringer wird, so dass am Strahlaustritt (B) annähernd der Wert Null erreicht ist.

11. Beleuchtungskondensor nach einem der Ansprüche 1 bis 10, **dadurch gekennzeichnet, dass** die magnetische Feldstärke (24) über die partiellen Linsen (14, 15, 18, 17, 18) so eingestellt ist, dass der Quell-Crossover (310) einer Elektronenkanone (30) im objektseitigenseitigen Brennpunkt des Beleuchtungskondensor (10) steht und in das Unendliche abgebildet ist.

12. Beleuchtungskondensor nach einem der Ansprüche 1 bis 11, **dadurch gekennzeichnet, dass** die magnetische Feldstärke (24) über die partiellen Linsen (14, 15, 16, 17, 18) so eingestellt ist, dass der Beleuchtungskondensor (10) eine lange Brennweite aufweist, die um die 500 mm beträgt.

13. Beleuchtungskondensor nach einem der Ansprüche 1 bis 12, **dadurch gekennzeichnet, dass** der Beleuchtungskondensor mit einer elektrostatischen Zerstreuungslinse kombiniert ist.

14. Beleuchtungskondensor nach einem der Ansprüche 1 bis 12, **dadurch gekennzeichnet, dass** der Beleuchtungskondensor aus einer Dublette von zwei Mehrspalt-Linsen zusammengesetzt ist.

## Claims

1. An illumination condenser (10) for a particle optics projection system comprising an illumination condenser (10) being constituted by a magnetic lens (11), said magnetic lens (11) comprising a plurality of gaps, **characterised in that** the magnetic lens is formed of a sequence of a plurality of partial lenses (14, 15, 16, 17, 18), wherein each of said partial lenses (14, 15, 16, 17, 18) comprises a separate winding (14a, 15a, 16a, 17a, 18a).

2. The illumination condenser according to claim 1, **characterised in that** the number of gaps is greater than five.

3. The illumination condenser according to claim 1, **characterised in that** the number of gaps is five.

4. The illumination condenser according to claim 1, **characterised in that** each of the separate windings (14a, 15a, 16a, 17a, 18a) of the plurality of partial lenses (14, 15, 16, 17, 18) is controllable individually.

5. The illumination condenser according to claim 1, **characterised in that** each of the plurality of partial lenses (14, 15, 16, 17, 18) comprises first separate windings (14a, 15a, 16a, 17a, 18a) and second separate windings (14b, 15b, 16b, 17b, 18b), wherein the turns ratio of the first windings (14a, 15a, 16a, 17a, 18a) and of the second windings (14b, 15b, 16b, 17b, 18b) is selected such that the partial lenses (14, 15, 16, 17, 18) obtain the desired excitation when the first windings (14a, 15a, 16a, 17a, 18a) are operated in a series connection and the second windings (14b, 15b, 16b, 17b, 18b) are operated in a series connection.

6. The illumination condenser according to claim 5, **characterised in that** the same constant current flows through the first windings (coarse windings) (14a, 15a, 16a, 17a, 18a) of the partial lenses (14, 15, 16, 17, 18) and each of the second windings (fine windings) (14b, 15b, 16b, 17b, 18b) of the partial lenses (14, 15, 16, 17, 18) has a different excitation as a consequence of the individual numbers of turns in a series connection, when the same current flows through them, wherein a sensitive focal length variation is adjustable by varying the current of the fine windings (14b, 15b, 16b, 17b, 18b) operated in a series connection.

7. The illumination condenser according to claim 1, **characterised in that** at least two adjacent partial lenses (14, 15, 16, 17, 18) share a common pole piece (19), wherein the gaps of the partial lenses (14, 15, 16, 17, 18) located between the pole pieces (19) and/or the diameters of the pole pieces (19) differ from each other.

8. The illumination condenser according to any one of claims 1 to 7, **characterised in that** the particle optics projection system (2) defines an optical axis (32) around which the illumination condenser (10) is constructed so as to be rotationally symmetric.

9. The illumination condenser according to claim 8, **characterised in that** the aberration of a source crossover (310) is minimized, wherein a maximum bore hole radius Rk of the illumination condenser (10) has a value that is less than 150 mm.

10. The illumination condenser according to claim 9, **characterised in that** the magnetic field strength (24) is decreased via each of the partial lenses (14, 15, 16, 17, 18) such that it has approximately reached the value of zero at the beam exit (B).

11. The illumination condenser according to any one of claims 1 to 10, **characterised in that** the magnetic field strength (24) is adjusted via the partial lenses (14, 15, 16, 17, 18) such that the source crossover (310) of an electron gun (30) lies in the object-side focal point of the illumination condenser (10) so that the source crossover (310) is imaged at infinity.

12. The illumination condenser according to any one of claims 1 to 11, **characterised in that** the magnetic field strength (24) is adjusted via the partial lenses (14, 15, 16, 17, 18) such that the illumination condenser (10) has a long focal length of around 500 mm.

13. The illumination condenser according to any one of claims 1 to 12, **characterised in that** the illumination condenser is combined with an electrostatic diverging lens.

14. The illumination condenser according to any one of claims 1 to 12, **characterised in that** the illumination condenser comprises a doublet of two multiple-gap lenses.

## Revendications

1. Condenseur d'illumination (10) pour un système de projection optique à particules, comprenant un condenseur d'illumination (10) qui est constitué d'une lentille magnétique (11) présentant plusieurs fentes, **caractérisé en ce que** la lentille magnétique est constituée d'une séquence de plusieurs lentilles partielles (14, 15, 16, 17, 18), dont chacune comprend un bobinage séparé (14a, 15a, 16a, 17a, 18a).

2. Condenseur d'illumination selon la revendication 1, **caractérisé en ce que** le nombre de fentes est supérieur à cinq.

3. Condenseur d'illumination selon la revendication 1, **caractérisé en ce que** le nombre de fentes est égale à cinq.

4. Condenseur d'illumination selon la revendication 1, **caractérisé en ce que** chacun des bobinages séparés (14a, 15a, 16a, 17a, 18a) desdites plusieurs lentilles partielles (14, 15, 16, 17, 18) est individuellement contrôlable.

5. Condenseur d'illumination selon la revendication 1, **caractérisé en ce que** chacune des plusieurs lentilles partielles (14, 15, 16, 17, 18) comprend des premiers bobinages séparés (14a, 15a, 16a, 17a, 18a) et des deuxièmes bobinages séparés (14b, 15b, 16b, 17b, 18b), les nombres de spires des premiers bobinages (14a, 15a, 16a, 17a, 18a) et des deuxièmes bobinages (14b, 15b, 16b, 17b, 18b) étant choisis de sorte que les lentilles partielles (14, 15, 16, 17, 18) obtiennent l'excitation désirée lorsque les premiers bobinages (14a, 15a, 16a, 17a, 18a) sont opérés dans un montage en série et les deuxièmes bobinages (14b, 15b, 16b, 17b, 18b) sont opérés dans un montage en série.

6. Condenseur d'illumination selon la revendication 5, **caractérisé en ce que** le même courant constant circule dans les premiers bobinages (bobinages larges) (14a, 15a, 16a, 17a, 18a) des lentilles partielles (14, 15, 16, 17, 18) et les deuxièmes bobinages (bobinages fins) (14b, 15b, 16b, 17b, 18b) des lentilles partielles (14, 15, 16, 17, 18) présentent chacun une excitation différente résultant des nombres de spires individuelles dans un montage en série, lorsque le même courant circule dans lesdits bobinages, une variation délicate de la distance focale étant réglable par variation du courant dans les bobinages fins (14b, 15b, 16b, 17b, 18b) étant opérés dans un montage en série.

7. Condenseur d'illumination selon la revendication 1, **caractérisé en ce qu'**au moins deux lentilles partielles (14, 15, 16, 17, 18) adjacentes se partagent une pièce polaire (19), les fentes des lentilles partielles (14, 15, 16, 17, 18) étant disposées entre les pièces polaires (19) et/ou les diamètres des pièces polaires (19) se distinguant les uns des autres.

8. Condenseur d'illumination selon l'une quelconque des revendications 1 à 7, **caractérisé en ce que** le système de projection optique à particules (2) définit un axe optique (32) autour duquel le condenseur d'illumination (10) est construit de manière à présenter une symétrie de rotation.

9. Condenseur d'illumination selon la revendication 8, **caractérisé en ce que** l'aberration d'un croisement de sources (310) est minimisée, un rayon d'alésage maximum Rk du condenseur d'illumination (10) présentant une valeur inférieure à 150 mm.

10. Condenseur d'illumination selon la revendication 9, **caractérisé en ce que** l'intensité du champs magnétique (24) est réduite au moyen de chaque lentille partielle (14, 15, 16, 17, 18) de manière à s'approcher à la valeur de zéro à la sortie du faisceau (B).

11. Condenseur d'illumination selon l'une quelconque des revendications 1 à 10, **caractérisé en ce que** l'intensité du champs magnétique (24) est réglée au moyen des lentilles partielles (14, 15, 16, 17, 18) de manière à ce que le croisement de sources (310) d'un canon à électrons (30) soit situé dans le point focal objet du condenseur d'illumination (10) de manière à imager le croisement de sources (310) en infinité.

12. Condenseur d'illumination selon l'une quelconque des revendications 1 à 11, **caractérisé en ce que** l'intensité du champs magnétique (24) est réglée au moyen des lentilles partielles (14, 15, 16, 17, 18) de sorte que le condenseur d'illumination (10) présente une longue focale d'environ 500 mm.

13. Condenseur d'illumination selon l'une quelconque des revendications 1 à 12, **caractérisé en ce que** le condenseur d'illumination est combiné avec une lentille divergente électrostatique.

14. Condenseur d'illumination selon l'une quelconque des revendications 1 à 12, **caractérisé en ce que** le condenseur d'illumination est composé d'un doublet de deux lentilles à fentes multiples.
